# EUROPÄISCHE PATENTANMELDUNG

(11) **EP 1 515 440 A2**
(43) Veröffentlichungstag der Anmeldung: **16.03.2005**
(21) Anmeldenummer: 04016290.1
(22) Anmeldetag: 10.07.2004
(51) Int. Cl.: H03K 17/082

(54) **Transistorschaltung mit Spannungsbegrenzungseinrichtung und Verwendung eines Basis-Emitter-Widerstands**

(30) Priorität: 05.09.2003 DE 10340937
(71) Anmelder: ROBERT BOSCH GMBH, 70442 Stuttgart (DE)
(72) Erfinder: Flohrs, Peter, 72770 Reutlingen (DE); Michel, Hartmut, 72762 Reutlingen (DE)

(57) **Zusammenfassung**

Die Erfindung betrifft eine Transistorschaltung (1) mit mindestens einem Transistor (2) und einer die Kollektor-Emitter-Spannung des Transistors begrenzenden Spannungsbegrenzungseinrichtung (3), wobei die Spannungsbegrenzungseinrichtung (3) einen dem Transistor (2) zugeordneten Basis-Emitter-Widerstand (4) aufweist, dessen Widerstandswert in Abhängigkeit einer vorgewählten Durchbruchspannung der Kollektor-Emitter-Strecke des Transistors (2) bestimmt ist. Zudem betrifft die Erfindung eine Zündanlage mit einer Transistorschaltung (1) sowie die Verwendung eines Basis-Emitter-Widerstands (4) zum Zwecke der mittels Spannungsdurchbruch erfolgenden Spannungsbegrenzung der Kollektor-Emitter-Strecke eines Transistors (2), beziehungsweise der Beeinflussung der Durchbruchsspannung der Kollektor-Emitter-Strecke eines Transistors (2).

## Beschreibung

Die Erfindung betrifft eine Transistorschaltung mit mindestens einem Transistor und einer die Kollektor-Emitter-Spannung des Transistors begrenzenden Spannungsbegrenzungseinrichtung gemäß dem unabhängigen Anspruch 1, die Zündanlage eines Kraftfahrzeugs mit einer Transistorschaltung gemäß dem Anspruch 11, sowie die Verwendung eines Basis-Emitter-Widerstands einer mindestens einen Transistor aufweisenden Transistorschaltung gemäß dem unabhängigen Anspruch 12.

### Stand der Technik

Beim Einsatz von Transistoren ist es oft erforderlich, die Kollektor-Emitter-Spannung des Transistors zu begrenzen, um sowohl den Transistor selbst als auch die mit dem Transistor verbundene elektrische Last vor Spannungsüberhöhungen beziehungsweise Spannungsspitzen zu schützen. Zur Spannungsbegrenzung der Kollektor-Emitter-Spannung sind aus dem Stand der Technik eine Vielzahl von Möglichkeiten bekannt. Beispielhaft sei dabei auf die DE 32 27 536 A1 und die EP 0 551 293 B1 verwiesen. Gemeinsam ist bei den bekannten Konzepten, dass die Kollektor-Emitter-Spannung auf einen Wert unterhalb der Durchbruchsspannung des Transistors begrenzt wird. Damit ergibt sich ein Sicherheitsabstand zwischen der mittels der Spannungsbegrenzung bewirkten Maximalspannung und der Durchbruchsspannung.

### Vorteile der Erfindung

Bei einer Transistorschaltung mit mindestens einem Transistor und einer die Kollektor-Emitter-Spannung des Transistors begrenzenden Spannungsbegrenzungseinrichtung weist die Spannungsbegrenzungseinrichtung erfindungsgemäß einen dem Transistor zugeordneten Basis-Emitter-Widerstand auf, dessen Widerstandswert in Abhängigkeit einer vorgewählten Durchbruchsspannung der Kollektor-Emitter-Strecke des Transistors bestimmt ist. Damit ist eine Möglichkeit aufgezeigt, den internen Spannungsdurchbruch des Transistors zur Spannungsbegrenzung zu verwenden, bei gleichzeitiger Beibehaltung eines engen Toleranzbands, in dem der Maximalwert der begrenzten Spannung liegen soll. Da nunmehr der Spannungsdurchbruch des Transistors zur Spannungsbegrenzung verwendet wird, kann auf eine aufwendige Zusatzbeschaltung zur Spannungsbegrenzung verzichtet werden. Damit lassen sich entweder diskrete Bauteile oder aber -bei einer integrierten Ausführung- Chipfläche sparen. Die Bestimmung des Widerstandswerts des Basis-Emitter-Widerstands in Abhängigkeit von einer vorgewählten Durchbruchsspannung wird an anderer Stelle dieser Schrift erläutert.

Gemäß einer Weiterbildung der Erfindung ist der Transistor ein Leistungstransistor.

Bei einer weiteren Ausgestaltung der Erfindung ist der Leistungstransistor ein dreifach-diffundierter Leistungstransistor. Hierbei wird üblicherweise zu der Schichtenfolge "n+", "p-" und "n-" von der Rückseite des Transistor her eine weitere "n+"-Schicht eindiffundiert. Der Abstand von der Oberfläche bis zur rückseitigen "n+"-Schicht wird mit der Variablen xi bezeichnet.

Vorteilhafterweise ist der Widerstandswert des Basis-Emitter-Widerstands anpassbar. Damit wird es möglich, eine große Menge von Transistorschaltungen mittels desselben Produktionsverfahrens herzustellen und dann in einem weiteren Schritt den Basis-Emitter-Widerstand so abzugleichen, dass sich die gewünschte Durchbruchsspannung der Kollektor-Emitter-Strecke einstellt. Beispielhaft sei dazu folgende Vorgehensweise aufgezeigt: Die Durchbruchsspannung des Transistors in der Transistorschaltung wird gemessen und mit einem gewünschten Sollwert verglichen. Anhand von theoretisch berechneten und/oder empirisch ermittelten Daten wird ein Abgleichschritt bestimmt und ausgeführt, der den Widerstandswert des Basis-Emitter-Widerstands derart ändert, dass die Durchbruchsspannung des Transistors dem gewünschten Sollwert entspricht oder in einem engen Toleranzband um diesen Sollwert liegt.

Mit Vorteil ist der Basis-Emitter-Widerstand aus einer Parallelschaltung eines ersten, festen Widerstandsanteils und eines zweiten, anpassbaren Widerstandsanteils gebildet. Mittels des ersten Widerstandsanteils wird der Widerstandswert des Basis-Emitter-Widerstands grob eingestellt. Anhand des zweiten Widerstandsanteils wird dann eine Feinjustierung des Widerstandswerts des Basis-Emitter-Widerstands vorgenommen. Üblicherweise ist der Widerstandswert des zweiten Widerstandsanteils größer als der Widerstandswert des ersten Widerstandsanteils, da dies einen besonders genauen Abgleich des Widerstandswerts des Basis-Emitter-Widerstands erlaubt

Eine vorteilhafte Ausgestaltung ergibt sich, wenn der Basis-Emitter-Widerstand oder der zweite Widerstandsanteil ein Widerstandsarray mit mindestens einer Widerstandsanordnung, bestehend aus einem Widerstand und einem dazu in Reihe geschalteten Aktivierungselement, aufweist. Das Widerstandsarray stellt eine bestimmte Anzahl an Widerständen zur Verfügung, wobei jedem Widerstand ein Aktivierungselement zugeordnet ist. Durch ein selektives Aktivieren bestimmter Widerstände des Widerstandsarrays mittels der Aktivierungselemente lässt sich der zweite Widerstandsanteil gewünscht anpassen.

Mit Vorteil ist das Aktivierungselement eine Zenerdiode, wobei die Zenerdiode so ausgeführt ist, dass sie bei Beaufschlagung mit einer Überspannung in einen niederohmigen Zustand durchlegiert' wird. Die Zenerdiode wird dabei üblicherweise in Sperrrichtung betrieben und stellt unterhalb ihrer Durchbruchspannung einen großen Widerstand dar. Dadurch tritt auch der zur Zenerdiode in Reihe geschaltete Widerstand elektrisch nicht in Erscheinung, so dass eine Widerstandsanordnung mit einer funktionstüchtigen Zenerdiode keinen Einfluss auf den Gesamtwiderstand des Widerstandsarrays nimmt. Wird die Zenerdiode mit einer Überspannung beaufschlagt, die betragsmäßig oberhalb ihrer Durchbruchsspannung liegt, so legiert die Zenerdiode in einen niederohmigen Zustand durch. Dies führt dazu, dass der zu ihr in Reihe geschaltete Widerstand mit seiner elektrischen Eigenschaft in Erscheinung tritt und den Gesamtwiderstand des Widerstandsarrays und damit auch den Widerstandswert des Basis-Emitter-Widerstands beeinflusst. Mittels eines selektiven Durchlegierens bestimmter Zenerdioden (Zenerzapping) wird das Widerstandsarray mit einem gewünschten Gesamtwiderstandswert versehen.

Vorteilhafterweise hat der Basis-Emitter-Widerstand einen positiven Temperaturkoeffizienten, der vorzugsweise je 100 Kelvin den Widerstandswert etwa verdoppelt. Es hat sich gezeigt, dass die Durchbruchsspannung des Transistors in der Transistorschaltung mit zunehmender Temperatur des Transistors steigt. Dies bedeutet, dass sich die Durchbruchsspannung bei einer bestimmten Temperatur durch eine geeignete Wahl des Widerstandswerts des Basis-Emitter-Widerstands einstellen lässt, dass sich die Durchbruchsspannung aber ändert, wenn die Transistorschaltung bei einem anderen Temperaturpunkt als dem während des Abgleichvorgangs betrieben wird.

Wie nachstehend noch genauer erläutert wird, wurde im Rahmen der Erfindung erkannt, dass einer Erhöhung der Durchbruchsspannung bei steigender Temperatur durch eine Erhöhung des Widerstandswerts des Basis-Emitter-Widerstands entgegengewirkt werden kann. Da eine von außen vorgenommene Nachjustierung des Basis-Emitter-Widerstands oftmals nicht praktikabel ist, wird die Erhöhung des Widerstandswerts des Basis-Emitter-Widerstands dadurch bewirkt, dass der Basis-Emitter-Widerstand einen positiven Temperaturkoeffizienten hat. Dies bedeutet, dass der Widerstandswert mit steigender Temperatur ansteigt. Versuche haben dabei für einige Transistoren ergeben, dass der Temperaturkoeffizient den Widerstandswert vorzugsweise je 100 Kelvin etwa verdoppeln sollte.

Ein weiterer Vorteil ergibt sich, wenn der Basis-Emitter-Widerstand mittels einer in einem Halbleiter integrierten Widerstandsschicht ausgeführt ist. Weist eine integrierte Widerstandsschicht einen Quadratwiderstand von beispielsweise 1000 Ohm/sq auf, so lässt sich durch 100 parallel geschaltete Quadrate ein Widerstand von 10 Ohm realisieren. Die Quadrate lassen sich platzsparend als Schlitz zwischen "p"-Kanten mit seitlicher Begrenzung durch "n-"-Isolationsfinger ausbilden.

Bei einer vorteilhaften Weiterbildung der Erfindung ist der zweite Widerstandsanteil von einer selbstjustierenden Anpassungsschaltung gebildet, die die mittels des Basis-Emitter-Widerstands bewirkte Gegenkopplung so beeinflusst, dass sich die gewünschte Durchbruchsspannung des Transistors einstellt. Mittels einer derartigen Anpassungsschaltung kann auf den zuvor beschriebenen Abgleich des Basis-Emitter-Widerstands verzichtet werden, da sich die gewünschte Durchbruchsspannung in einem gewissen Toleranzband selbstjustierend einstellt. Ein Beispiel einer solchen Anpassungsschaltung wird in einem nachfolgenden Teil dieser Schrift vorgestellt.

Des Weiteren betrifft die Erfindung eine Zündanlage eines Kraftfahrzeugs mit einer vorstehend beschriebenen Transistorschaltung. Dabei wird die Transistorschaltung üblicherweise primärseitig eingesetzt, wobei der Transistor vom primärseitigen Zündstrom durchflossen wird.

Ferner umfasst die Erfindung die Verwendung eines Basis-Emitter-Widerstands einer mindestens einen Transistor aufweisenden Transistorschaltung zum Zwecke der mittels Spannungsdurchbruch erfolgenden Spannungsbegrenzung der Kollektor-Emitter-Strecke des Transistors, beziehungsweise der Beeinflussung der Durchbruchsspannung der Kollektor-Emitter-Strecke des Transistors, wobei der Widerstandswert des Basis-Emitter-Widerstands in Abhängigkeit einer vorgewählten Durchbruchspannung der Kollektor-Emitter-Strecke des Transistors bestimmt ist.

### Zeichnungen

Die Erfindung wird anhand der nachfolgenden Zeichnungen näher erläutert. Es zeigen:
- Figur 1: ein Ausführungsbeispiel einer erfindungsgemäßen Transistorschaltung,
- Figur 2: einen beispielhaften Verlauf der Durchbruchsspannung von Transistoren in Abhängigkeit vom Widerstandswert des Basis-Emitter-Widerstands,
- Figur 3: einen beispielhaften Verlauf der Durchbruchsspannung von Transistoren in Abhängigkeit von der Temperatur des Basis-Emitter-Widerstands und des Abstands xi, und
- Figur 4: ein Schaltbild einer beispielhaften selbstjustierenden Anpassungsschaltung.

### Beschreibung der Figuren

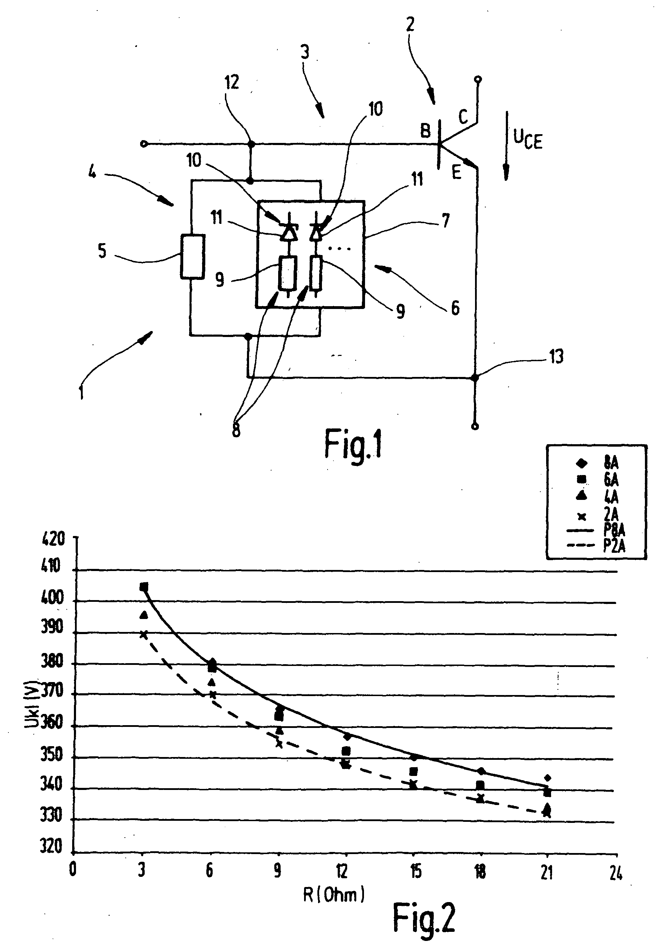

Figur 1 zeigt eine Transistorschaltung 1 mit einem Transistor 2, an dessen Kollektor-Emitter-Strecke die Spannung U_{CE} abfällt, sowie mit der Spannungsbegrenzungseinrichtung 3. Die Spannungsbegrenzungseinrichtung 3 weist einen Basis-Emitter-Widerstand 4 auf, der eine Parallelschaltung aus einem ersten, festen Widerstandsanteil 5 und einem zweiten, anpassbaren Widerstandsanteil 6 umfasst, der hier als Widerstandsarray 7 ausgeführt ist. Der zweite Widerstandsanteil 6 weist mehrere Widerstandsanordnungen 8 auf, die jeweils aus einem Widerstand 9 und einem dazu in Reihe geschalteten Aktivierungselement 10 (hier als Zenerdiode 11 ausgeführt) bestehen.

Der Basis-Emitter-Widerstand ist am Basisknoten 12 an die Basis des Transistors 2 angeschlossen und am Emitterknoten 13 an den Emitter des Transistors 2. Dadurch wird bewirkt, dass ein Teil des zur Basis des Transistors 2 fließenden Ansteuerstroms durch den Basis-Emitter-Widerstand 4 fließt -und damit an der Basis-Emitter-Strecke des Transistors 2 vorbei-, wodurch die Durchbruchsspannung des Transistors 2 beeinflusst wird. Wie bereits zuvor beschrieben, wird der Widerstandswert des Basis-Emitter-Widerstands 4 durch die Größe des ersten Widerstandsanteils 5 und die selektive Aktivierung einzelner Widerstandsanordnungen 8 so eingestellt, dass sich die gewünschte Durchbruchsspannung einstellt.

Figur 2 zeigt den Verlauf der Durchbruchsspannung eines Transistors 2 in Abhängigkeit vom Widerstandswert des Basis-Emitter-Widerstands 4 bei unterschiedlichen Kollektor-Emitter-Strömen (2A, 4A, 6A und 8A). Im hier gezeigten Beispiel lässt sich erkennen, dass die Durchbruchsspannung des Transistors 2 bei einem Strom von 2A und einem Widerstandswert des Basis-Emitter-Widerstands 4 von 21 Ohm etwas oberhalb von 330 V liegt. Wird der Basis-Emitter-Widerstand 4 auf 6 Ohm reduziert, so steigt die Durchbruchsspannung um ungefähr 40 V auf 370 V. Bei Betrachtung der einzelnen Messwerte und der zur Verdeutlichung eingezeichneten Trendlinien P2A und P8A wird deutlich, dass ein determinierbarer funktionaler Zusammenhang zwischen dem Widerstandswert des Basis-Emitter-Widerstands 4 und der Durchbruchsspannung des Transistors 2 besteht. Aus dieser Erkenntnis lässt sich ein zielstrebiges Vorgehen bei der Wahl beziehungsweise Abstimmung des Basis-Emitter-Widerstands 4 ableiten.

Anhand des im Wesentlichen exponentiell abklingenden Verlaufs der Durchbruchsspannung bei steigendem Widerstandswert des Basis-Emitter-Widerstands 4 lässt sich ermitteln, um welchen Betrag der Widerstandswert des Basis-Emitter-Widerstands 4 durch ein Einstellen des zweiten Widerstandsanteils 6 reduziert werden muss, damit sich eine gewünschte Durchbruchsspannung des Transistors 2 einstellt. Beispielhaft sei angenommen, dass der erste Widerstandsanteil 5 einen Widerstandswert von 18 Ohm aufweist und dass die aktuell gemessene Durchbruchsspannung des Transistors 2 10 V unterhalb der gewünschten Durchbruchsspannung liegt. Aus dem Kurvenverlauf lässt sich ableiten, dass der Widerstandswert des Basis-Emitter-Widerstands 4 um 6 Ohm reduziert werden muss, damit sich die Durchbruchsspannung um 10 V erhöht. Um diese Reduzierung des Widerstandswerts zu bewirken, wird der zweite Widerstandsanteil 6 auf einen Wert von 36 Ohm -oder den nächstmöglich realisierbaren Wert- eingestellt, da sich dann durch die Parallelschaltung des ersten Widerstandsanteils 5 mit 18 Ohm und des zweiten Widerstandsanteils 6 mit 36 Ohm ein Widerstandswert des Basis-Emitter-Widerstands 4 von (ungefähr) 12 Ohm einstellt. Damit ist die gewünschte Einstellung der Durchbruchsspannung bewirkt. Auf diese Weise lässt sich bei einer beliebigen Anzahl von Transistoren 2 die Durchbruchsspannung auf einen gewünschten Sollwert, beziehungsweise innerhalb eines engen Toleranzbands um diesen Sollwert, einstellen.

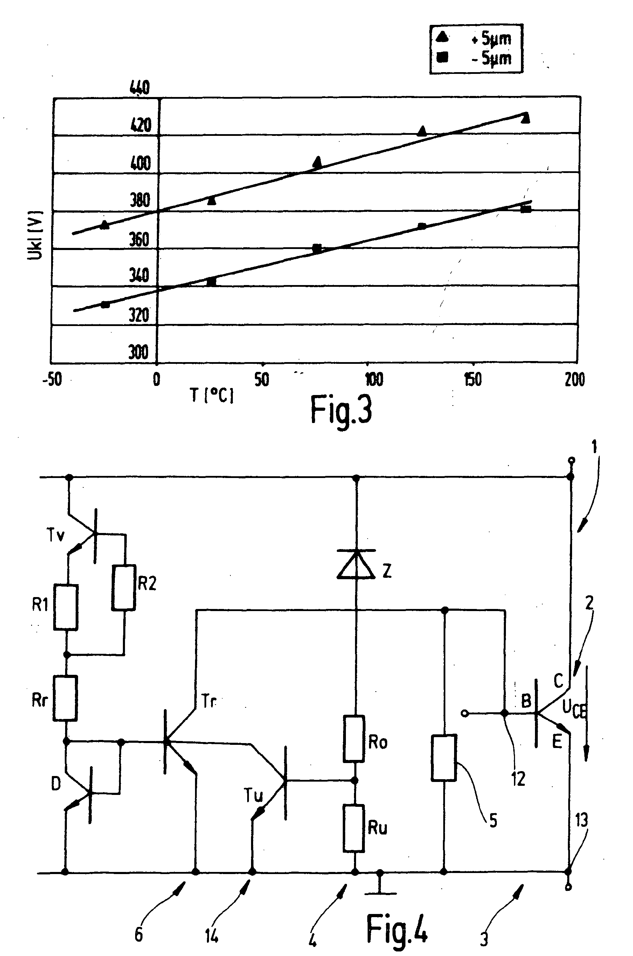

Figur 3 zeigt den Verlauf der Durchbruchsspannung des Transistors 2 in Abhängigkeit von seiner Temperatur. Des Weiteren zeigt die Figur, welche Varianz der Durchbruchsspannung zu erwarten ist, wenn der Abstand xi der rückseitigen "n+"-Diffusionsschicht zur Oberfläche des Transistors um 5 µm nach oben beziehungsweise nach unten hin abweicht. Aus diesem Beispielsdiagramm lässt sich zum Beispiel entnehmen, dass die Durchbruchsspannung bei einer Erhöhung der Transistortemperatur um 100 Kelvin um ungefähr 25 V ansteigt. Unter Berücksichtigung der in Figur 2 aufgezeigten Zusammenhänge lässt sich damit zum Beispiel ableiten, welchen Temperaturkoeffizienten der Basis-Emitter-Widerstand 4 aufweisen sollte, um bei einer Erhöhung der Temperatur des Transistors 2 eine Erhöhung der Durchbruchsspannung zu verringern oder zu vermeiden. Des Weiteren ist dem Diagramm zu entnehmen, dass bei einer Streuung der Schichtdicke um +/- 5 µm eine Streuung der Durchbruchsspannung von ungefähr +/- 20 V zu erwarten ist.

Figur 4 zeigt eine Transistorschaltung 1, bei der der zweite Widerstandsanteil 6 des Basis-Emitter-Widerstands 4 als Anpassungsschaltung 14 ausgeführt ist. Aufgabe der Anpassungsschaltung 14 ist es, einen Strom über den Transistor Tr an der Basis-Emitter-Strecke vorbeizuführen -mit ähnlicher Wirkung wie ein variabler Widerstand-, wobei der Strom umso geringer ist, beziehungsweise der effektive Widerstand umso größer ist, je höher die Durchbruchsspannung ist. Das heißt, mittels der Anpassungsschaltung wird eine höhere Durchbruchsspannung in einem geringeren Maße angehoben als eine niedrigere Durchbruchsspannung. Damit lässt sich die Vergleichmäßigung der Durchbruchsspannung von Transistoren 2 in verschiedenen Transistorschaltungen 1 erreichen. Da der Transistor Tr mit seinem einstellbaren Kollektor-Emitter-Stromfluss ähnlich einem variablen Widerstand wirkt, ergibt sich in Zusammenwirkung mit dem parallel geschalteten ersten Widerstandsanteil 5 ein insgesamt variabler Basis-Emitter-Widerstand 4.

An die Kollektorseite des Transistors 2 ist ein integrierter Vertikaltransistor Tv angeschlossen, der durch die gezeigte Widerstands-Gegenkopplung mittels der Widerstände R1 und R2 eine Durchbruchsspannung etwas unterhalb der Durchbruchsspannung des Transistors 2 aufweist. Überschreitet die Kollektorspannung die Durchbruchsspannung des Transistors Tv, so fließt über den Transistor Tv, den Widerstand R1 und den Widerstand Rr ein Strom zur Basis des Transistors Tr, der durch den zur Diodenfunktion beschalteten Transistor D auf eine konstante Stromverstärkung, zum Beispiel von 10, gesetzt ist. Die Bestromung des Basisbereichs des Transistors Tr führt dazu, dass eine zusätzliche Stromabfuhr von der Basis des Transistors 2 über den Basis-Emitter-Widerstand zum Emitterknoten 13 stattfindet. Der Widerstand Rr ist dabei so auszulegen, dass der Transistor Tr die zuvor beschriebene Wirkung eines geeignet dimensionierten, variablen Widerstands übernehmen kann. So kann der Widerstand Rr beispielsweise derart dimensioniert werden, dass der Transistor Tr in einem Intervall der Durchbruchsspannung zwischen 340 V und 380 V die Wirkung eines zwischen 15 Ohm und unendlich variierbaren Widerstands zeigt. Da der Kollektor-Emitter-Stromfluss durch den Transistor Tr nur die zum Erreichen der gewünschten Durchbruchspannung benötigte Höhe haben soll, muss der Kollektor-Emitter-Strom begrenzt werden. Dies geschieht mittels einer temperaturkompensierten Referenzspannung, die mittels der Zenerdiode Z, des Widerstands Ro und des Widerstands Ru realisiert wird. Durch die Ansteuerung der Basis des Transistors Tu wird dann ein Teil des Basisstroms des Transistors Tr über die Kollektor-Emitter-Strecke des Transistors Tu abgeführt. (Es sei angemerkt, dass der Transistor Tu einen negativen Temperaturkoeffizienten aufweist, während der Temperaturkoeffizient der Zenerdiode Z positiv ist.) Damit ist die selbstjustierende Funktion der Anpassungsschaltung 14 bewirkt.

## Patentansprüche

1. Transistorschaltung mit mindestens einem Transistor und einer die Kollektor-Emitter-Spannung des Transistors begrenzenden Spannungsbegrenzungseinrichtung, **dadurch gekennzeichnet, dass** die Spannungsbegrenzungseinrichtung (3) einen dem Transistor (2) zugeordneten Basis-Emitter-Widerstand (4) aufweist, dessen Widerstandswert in Abhängigkeit einer vorgewählten Durchbruchspannung der Kollektor-Emitter-Strecke des Transistors (2) bestimmt ist.

2. Transistorschaltung nach Anspruch 1, **dadurch gekennzeichnet, dass** der Transistor (2) ein Leistungstransistor ist.

3. Transistorschaltung nach einem der vorhergehenden Ansprüche, **dadurch gekennzeichnet, dass** der Leistungstransistor ein dreifach-diffundierter Leistungstransistor ist.

4. Transistorschaltung nach einem der vorhergehenden Ansprüche, **dadurch gekennzeichnet, dass** der Widerstandswert des Basis-Emitter-Widerstands (4) abgleichbar ist.

5. Transistorschaltung nach einem der vorhergehenden Ansprüche, **dadurch gekennzeichnet, dass** der Basis-Emitter-Widerstand (4) aus einer Parallelschaltung eines ersten, festen Widerstandsanteils (5) und eines zweiten, abgleichbaren Widerstandsanteils (6) gebildet ist.

6. Transistorschaltung nach einem der vorhergehenden Ansprüche, **dadurch gekennzeichnet, dass** der Basis-Emitter-Widerstand (4) oder der zweite Widerstandsanteil (6) ein Widerstandsarray (7) mit mindestens einer Widerstandsanordnung (8); bestehend aus einem Widerstand (9) und einem dazu in Reihe geschalteten Aktivierungselement (10), ist.

7. Transistorschaltung nach einem der vorhergehenden Ansprüche, **dadurch gekennzeichnet, dass** das Aktivierungselement (10) eine Zenerdiode (11) ist, wobei die Zenerdiode (11) so ausgeführt ist, dass sie bei Beaufschlagung mit einer Überspannung in einen niederohmigen Zustand durchlegiert wird.

8. Transistorschaltung nach einem der vorhergehenden Ansprüche, **dadurch gekennzeichnet, dass** der Basis-Emitter-Widerstand (4) einen positiven Temperaturkoeffizienten hat, der vorzugsweise je 100 Kelvin den Widerstandswert etwa verdoppelt.

9. Transistorschaltung nach einem der vorhergehenden Ansprüche, **dadurch gekennzeichnet, dass** der Basis-Emitter-Widerstand (4) mittels einer in einem Halbleiter integrierten Widerstandsschicht ausgeführt ist.

10. Transistorschaltung nach einem der vorhergehenden Ansprüche, **dadurch gekennzeichnet, dass** der zweite Widerstandsanteil (6) von einer selbstjustierenden Anpassungsschaltung gebildet ist, die die mittels des Basis-Emitter-Widerstands bewirkte Gegenkopplung so beeinflusst, dass sich die gewünschte Durchbruchsspannung des Transistors einstellt.

11. Zündanlage eines Kraftfahrzeugs, **gekennzeichnet durch** eine Transistorschaltung (1) nach einem oder mehreren der vorhergehenden Ansprüche.

12. Verwendung eines Basis-Emitter-Widerstands (4) einer mindestens einen Transistor (2) aufweisenden Transistorschaltung (1) zum Zwecke der mittels Spannungsdurchbruch erfolgenden Spannungsbegrenzung der Kollektor-Emitter-Strecke des Transistors (2), beziehungsweise der Beeinflussung der Durchbruchsspannung der Kollektor-Emitter-Strecke des Transistors (2), wobei der Widerstandswert des Basis-Emitter-Widerstands (4) in Abhängigkeit einer vorgewählten Durchbruchspannung der Kollektor-Emitter-Strecke des Transistors (2) bestimmt ist.
